# EUROPEAN PATENT SPECIFICATION

(11) **EP 1 741 283 B1**
(45) Date of publication and mention of the grant of the patent: **13.06.2012**
(21) Application number: 05730809.0
(22) Date of filing: 23.03.2005
(51) Int. Cl.: G02F 1/1335, H01L 51/10, H01L 27/15, H01J 17/49, G09F 9/30, H01L 51/52

(54) **BRIGHT LIQUID CRYSTAL DISPLAY WITH 4 WHITE SUBPIXELS CONTAINING COLOR SUBPIXEL REPEATING GROUP**
HELLE FLÜSSIGKRISTALLANZEIGE MIT EINER 4 WEISSE SUBPIXEL AUFWEISENDEN FARBSUBPIXEL-WIEDERHOLGRUPPE
AFFICHEUR LUMINEUX A CRISTAUX LIQUIDES COMPORTANT UN GROUPE REPETIF DE SOUS-PIXELS COLORES COMPRENANT 4 SOUS-PIXELS BLANCS

(30) Priority: 09.04.2004 US 821353; 07.10.2004 US 961506
(43) Date of publication of application: 10.01.2007
(73) Proprietor: Samsung Electronics Co., Ltd., Suwon-si, Gyeonggi-do (KR)
(72) Inventor: BROWN ELLIOTT, Candice Hellen, Vallejo, CA 94950 (US); THOMAS, Lloyd, Credelle, Morgan Hill, CA 95037 (US)
(74) Representative: Frost, Alex John
(86) International application number: PCT/US2005/010023
(87) International publication number: WO 2005/101807

(56) References cited:
- JP-A- 60 263 122
- JP-A- 2004 004 822
- JP-U- 61 124 082
- US-A1- 2002 191 130
- US-A1- 2004 080 479
- US-A1- 2004 174 389
- US-A1- 2005 007 327

## Description

### TECHNICAL FIELD

The present application relates to subpixel layouts for display devices and systems. Such subpixel layouts may include high brightness white subpixels, together with other color primary subpixels as well as multiprimary subpixel layouts.

### BACKGROUND

The present invention is a continuation-in-part application of United States Patent Application Serial Number 10/821,353 entitled "NOVEL SUBPIXEL LAYOUTS AND ARRANGEMENTS FOR HIGH BRIGHTNESS DISPLAYS" filed on April 9, 2004, and claims benefit of the priority date thereof.

In commonly owned United States Patent Applications: (1) United States Patent Application Serial No. 09/916,232 ("the '232 application" ), entitled "ARRANGEMENT OF COLOR PIXELS FOR FULL COLOR IMAGING DEVICES WITH SIMPLIFIED ADDRESSING," filed July 25, 2001; (2) United States Patent Application Serial No. 10/278,353 ("the '353 application"), entitled "IMPROVEMENTS TO COLOR FLAT PANEL DISPLAY SUB-PIXEL ARRANGEMENTS AND LAYOUTS FOR SUB-PIXEL RENDERING WITH INCREASED MODULATION TRANSFER FUNCTION RESPONSE," filed October 22, 2002; (3) United States Patent Application Serial No. 10/278,352 ("the '352 application"), entitled "IMPROVEMENTS TO COLOR FLAT PANEL DISPLAY SUB-PIXEL ARRANGEMENTS AND LAYOUTS FOR SUB-PIXEL RENDERING WITH SPLIT BLUE SUB-PIXELS," filed October 22, 2002; (4) United States Patent Application Serial No. 10/243,094 ("the '094 application), entitled "IMPROVED FOUR COLOR ARRANGEMENTS AND EMITTERS FOR SUB-PIXEL RENDERING," filed September 13, 2002; (5) United States Patent Application Serial No. 10/278,328 ("the '328 application"), entitled "IMPROVEMENTS TO COLOR FLAT PANEL DISPLAY SUB-PIXEL ARRANGEMENTS AND LAYOUTS WITH REDUCED BLUE LUMINANCE WELL VISIBILITY," filed October 22, 2002; (6) United States Patent Application Serial No. 10/278,393 ("the '393 application"), entitled "COLOR DISPLAY HAVING HORIZONTAL SUB-PIXEL ARRANGEMENTS AND LAYOUTS," filed October 22, 2002; (7) United States Patent Application Serial No. 01/347,001 ("the '001 application") entitled "IMPROVED SUB-PIXEL ARRANGEMENTS FOR STRIPED DISPLAYS AND METHODS AND SYSTEMS FOR SUB-PIXEL RENDERING SAME," filed January 16, 2003, novel sub-pixel arrangements are disclosed for improving the cost/performance curves for image display devices.

For certain subpixel repeating groups having an even number of subpixels in a horizontal direction, the following systems and techniques to affect improvements, e.g. proper dot inversion schemes and other improvements, are disclosed in : (1) United States Patent Application Serial Number 10/456,839 entitled "IMAGE DEGRADATION CORRECTION IN NOVEL LIQUID CRYSTAL DISPLAYS"; (2) United States Patent Application Serial No. 10/455,925 entitled "DISPLAY PANEL HAVING CROSSOVER CONNECTIONS EFFECTING DOT INVERSION"; (3) United States Patent Application Serial No. 10/455,931 entitled "SYSTEM AND METHOD OF PERFORMING DOT INVERSION WITH STANDARD DRIVERS AND BACKPLANE ON NOVEL DISPLAY PANEL LAYOUTS"; (4) United States Patent Application Serial No. 10/455,927 entitled "SYSTEM AND METHOD FOR COMPENSATING FOR VISUAL EFFECTS UPON PANELS HAVING FIXED PATTERN NOISE WITH REDUCED QUANTIZATION ERROR"; (5) United States Patent Application Serial No. 10/456,806 entitled "DOT INVERSION ON NOVEL DISPLAY PANEL LA YOUTS WITH EXTRA DRIVERS"; (6) United States Patent Application Serial No. 10/456,838 entitled "LIQUID CRYSTAL DISPLAY BACKPLANE LAYOUTS AND ADDRESSING FOR NON-STANDARD SUBPIXEL ARRANGEMENTS"; (7) United States Patent Application Serial No. 10/696,236 entitled "IMAGE DEGRADATION CORRECTION IN NOVEL LIQUID CRYSTAL DISPLAYS WITH SPLIT BLUE SUBPIXELS", filed October 28, 2003; and (8) United States Patent Application Serial No. 10/807,604 entitled "IMPROVED TRANSISTOR BACKPLANES FOR LIQUID CRYSTAL DISPLAYS COMPRISING DIFFERENT SIZED SUBPIXELS", filed March 23, 2004.

These improvements are particularly pronounced when coupled with sub-pixel rendering (SPR) systems and methods further disclosed in those applications and in commonly owned United States Patent Applications: (1) United States Patent Application Serial No. 10/051,612 ("the '612 application, entitled "CONVERSION OF RGB PIXEL FORMAT DATA TO PENTILE MATRIX SUB-PIXEL DATA FORMAT," filed January 16, 2002; (2) United States Patent Application Serial No. 10/150,355 ("the '355 application''), entitled "METHODS AND SYSTEMS FOR SUB-PIXEL RENDERING WITH GAMMA ADJUSTMENT," filed May 17, 2002; (3) United States Patent Application Serial No. 10/215,843 ("the '843 application"), entitled "METHODS AND SYSTEMS FOR SUB-PIXEL RENDERING WITH ADAPTIVE FILTERING," filed August 8, 2002; (4) United States Patent Application Serial No. 10/379,767 entitled "SYSTEMS AND METHODS FOR TEMPORAL SUB-PIXEL RENDERING OF IMAGE DATA" filed March 4, 2003; (5) United States Patent Application Serial No. 10/379,765 entitled "SYSTEMS AND METHODS FOR MOTION ADAPTIVE FILTERING," filed March 4, 2003; (6) United States Patent Application Serial No. 10/379,766 entitled "SUB-PIXEL RENDERING SYSTEM AND METHOD FOR IMPROVED DISPLAY VIEWING ANGLES" filed March 4, 2003; (7) United States Patent Application Serial No. 10/409,413 entitled "IMAGE DATA SET WITH EMBEDDED PRE-SUBPIXEL RENDERED IMAGE" filed April 7,2003.

Improvements in gamut conversion and mapping are disclosed in commonly owned and co-pending United States Patent Applications: (1) United States Patent Application Serial No. 10/691,200 entitled "HUE ANGLE CALCULATION SYSTEM AND METHODS", filed October 21, 2003; (2) United States Patent Application Serial No. 10/691,377 entitled "METHOD AND APPARATUS FOR CONVERTING FROM SOURCE COLOR SPACE TO RGBW TARGET COLOR SPACE", filed October 21, 2003; (3) United States Patent Application Serial No. 10/691,396 entitled "METHOD AND APPARATUS FOR CONVERTING FROM A SOURCE COLOR SPACE TO A TARGET COLOR SPACE", filed October 21, 2003; and (4) United States Patent Application Serial No. 10/690,716 entitled "GAMUT CONVERSION SYSTEM AND METHODS" filed October 21, 2003.

Additional advantages have been described in (1) United States Patent Application Serial No. 10/696,235 entitled "DISPLAY SYSTEM HAVING IMPROVED MULTIPLE MODES FOR DISPLAYING IMAGE DATA FROM MULTIPLE INPUT SOURCE FORMATS", filed October 28, 2003 and (2) United States Patent Application Serial No. 10/696,026 entitled "SYSTEM AND METHOD FOR PERFORMING IMAGE RECONSTRUCTION AND SUBPIXEL RENDERING TO EFFECT SCALING FOR MULTI-MODE DISPLAY" filed October 28, 2003.

Further background information may be found in: (1) United States Patent Application Serial No. [ATTORNEY DOCKET NUMBER 08831.0064] entitled "SYSTEM AND METHOD FOR IMPROVING SUB-PIXEL RENDERING OF IMAGE DATA IN NON-STRIPED DISPLAY SYSTEM:S"; (2) United States Patent Application Serial No. [ATTORNEY DOCKET NUMBER 08831.0065] entitled "SYSTEMS AND METHODS FOR SELECTING A WHITE POINT FOR IMAGE DISPLAY"; (3) United States Patent Application Serial No. [ATTORNEY DOCKET NUMBER 08831.0067] entitled "SYSTEMS AND METHODS FOR IMPROVED GAMUT MAPPING FROM ONE IMAGE DATA SET TO ANOTHER"; (4) United States Patent Application Serial No. [ATTORNEY DOCKET NUMBER 08831.0068] entitled "IMPROVED SUBPIXEL RENDERING FILTERS FOR HIGH BRIGHTNESS SUBPIXEL LAYOUTS (5) JP2004 004822; (6) US 2002/0191130 A1; (7) JP60263122; (8) JP61124082.

### DISCLOSURE OF THE INVENTION

The present invention provides a display as defined in claim 1.

Preferred embodiments of the present application provide a display dependent claims 2-14.

### BRIEF DESCRIPTION OF THE DRAWINGS

The accompanying drawings together with the description, serve to explain and understand principles of the invention.

**FIGS. 2 and 3** **and 19 and 20** are embodiments of high brightness layouts as made in accordance with the present invention. Figs. 1 and 4 show comparative examples.

**FIGS. 5A** and **5B** are side-by-side comparisons of conventional RGB stripe layouts.

**FIGS. 6A and 6B** are side-by-side comparisons of conventional RGB stripe layouts.

**FIGS. 7A and 7B** are side-by-side comparisons of conventional RGB stripe layouts.

**FIGS. 8 through 11A-C** are several other comparative examples of high brightness layouts not in accordance with the present invention.

**FIG. 12** is one embodiment of locating disclination regions with respect to black matrix for high brightness and other layouts.

**FIG 13** is a high brightness delta triad subpixel layout not in accordance with the present invention.

**FIG 14** **and** **15** are additional layouts similar to Figs. 2 and 3 but not in accordance with the present invention.

**FIG 16** is an additional comparative example similar to Fig. 4 wherein the colored subpixels form along a different diagonal line.

**FIG 17** is an additional comparative example that is similar to Fig 11A but wherein the colored planes are placed on a square grid.

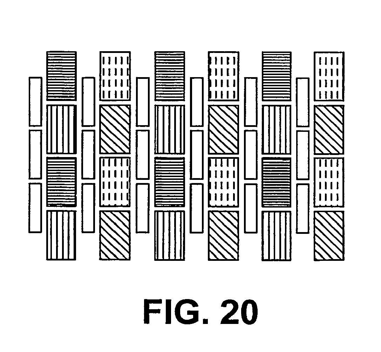

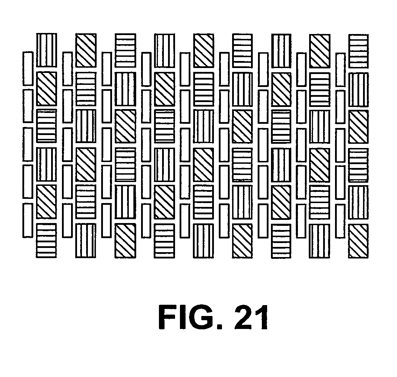

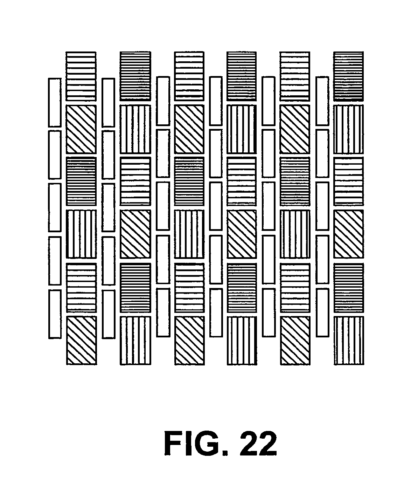

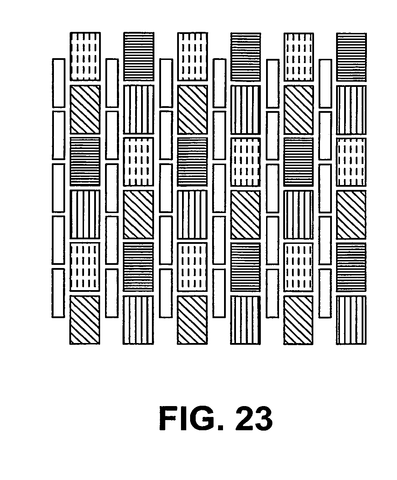

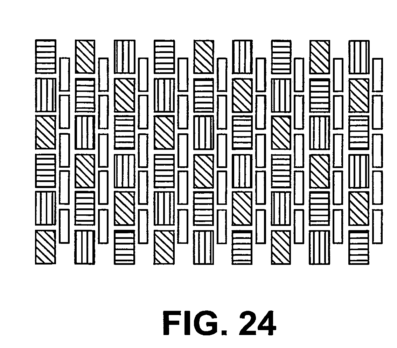

**FIG 18** **and** **2 to 24 are** additional layouts not in accordance with the present invention.

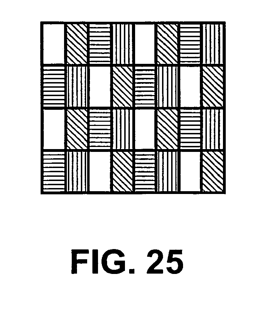

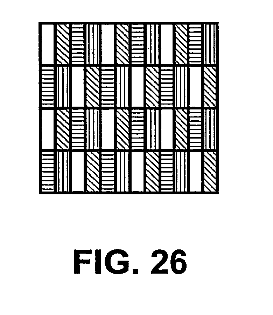

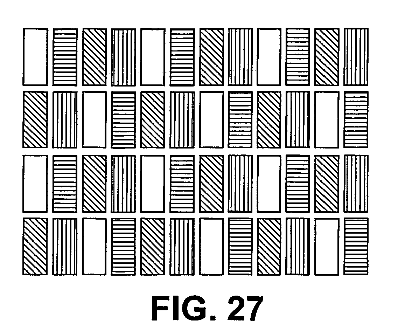

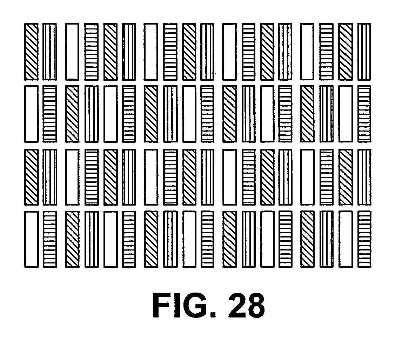

**FIG 25 to 28** are additional layouts not in accordance with the present invention of previous comparative examples but shown in mirror image.

### DETAILED DESCRIPTION

Reference will now be made in detail to implementations and embodiments, examples of which are illustrated in the accompanying drawings. Wherever possible, the same reference numbers will be used throughout the drawings to refer to the same or like parts.

### RGBW Color Liquid Crystal Displays and Natural Images

The "real world" is a subtractive color system. Save for relatively rare emissive light sources such as LEDs and lasers, high brightness saturated colors are not found in real world scenes that are viewed by the human vision system in the course of an individual going about his or her daily life. In daily experience, colors are formed by relatively bright white light falling on to pigmented objects that absorb some portion of the light and reflecting the rest. Colors are formed by selectively absorbing part of the spectrum and reflecting another part of the spectrum. Non-color-saturated objects such as white or pastel colored objects may substantially reflect most of the light, thus being radiometrically and visually brighter than saturated color objects. Conversely, objects that form saturated colors absorb most of the light and reflect only a narrow band (or bands in the case of purple or magenta) of the full spectrum of light falling on it. This reduces the brightness of saturated colored objects compared to non-saturated color objects. This is especially true for saturated colors that are near the corners of the color triangle of red, green, and blue, as to achieve these colors, the light must be in very narrow wavelength bands. Further, specular reflections occur at the surfaces of objects which do not substantially alter the spectrum of light falling on them, giving reflection highlights that are non-color-saturated, even on objects that are observed to be highly color-saturated in lambertian reflection. These highlights are the brightest portions of many natural scenes (e.g. the mirror like reflection of an overhead light on a brightly colored billiard ball is white, not colored). Thus, by their very nature, real world scenes may have bright non-color-saturated objects and darker color-saturated objects.

Some natural images have highly saturated colors. In these images, the brightest red, green, and blue colors are far darker than the white found in natural images. Even yellow, which may be formed from a mixture of red and green - may not be as bright as white. Other images - typically photographs of indoor objects (e.g. faces) -- might not have such brightly colored objects. When examining the statistical occurrence of highly saturated colors vs. non-saturated colors, one finds that saturated colors are relatively rare in natural images. When saturated colors do occur, they are quite dark. Further, given the subtractive nature of color formation in natural scenes, bright saturated colors are almost non-existent.

For electronic displays to render natural scenes, it might be best for it to be able to create very bright non-color-saturated colors and darker highly saturated colors. Upon inspection of the capabilities of the conventional three primary, RGB, system, one notes that it is a color additive system whose non-saturated color brightness is limited to the addition of partially-saturated colors. The brightness/saturation color gamut of the RGB system generally has brighter non-saturated colors, but fails to reproduce the very bright non-saturated colors.

There is a trade-off between the brightness of the non-saturated colors and the color saturation gamut of the filtered backlight display. The more saturated the color filters, the less these filtered colors may add to the non-saturated brightness. This creates a luminance/saturation compression in which the non-saturated colors are reduced in brightness and saturated colors are compressed, desaturated, to fit within the limitations of the compromise system. Another color formation system is required to better display natural images.

RGBW liquid crystal displays provide an additional primary: White. These White subpixels are substantially brighter than the Red, Green, and Blue subpixels since the White is formed by using a transparent filter that allows substantially all of the light through, while the other three colors are formed by filtering out all but a narrow band of the spectrum. Since such filters are not ideal bandpass filters, the transmissivity is less than 100% even in the desired bandpass wavelengths, which further darkens the subpixel. The White subpixel may have up to four or more times the brightness of the colored subpixels. Thus, the use of a white subpixel significantly increases the brightness of the panel when displaying non-saturated colors.

If one fourth of the area of the panel is used for the White subpixel, the brightnesses of the remaining RGB subpixels are reduced by one fourth. However, non-saturated colors may be formed with a contribution from the bright White subpixel, giving significantly higher brightness. The resulting panel has a brightness/color gamut envelope shape that is closer to that of the 'real world'. The loss of brightness of the saturated colors is an acceptable trade-off when considering the statistics of natural images. However, as the choice of conventional RGB primaries was a compromise between the desired saturation of the primaries and the brightness of non-saturated colors, the introduction of the White subpixel offers a new optimization point.

Since the White subpixel provides the majority of the brightness of non-saturated colors, the saturation of the RGB primaries may be increased with only minor decrease of brightness of the non-saturated colors. This decrease may be partially offset by increase in the aperture ratio of the 1:2 aspect ratio subpixel for some (e.g. small) panels, with its reduced horizontal subpixel density, compared to the 1:3 aspect ratio subpixel found in conventional RGB stripe displays. This may result in an RGBW display that has both increased brightness and saturation envelope at every point compared to the conventional RGB display. Fully saturated colors may be darker on the optimized RGBW system compared to the RGB system, but at the saturation maximum color points of the RGB system, the RGBW brightness may be the same or higher. Thus, no real loss of color brightness occurs.

Such a RGBW system more closely approaches the 'real world' natural image envelop and statistics, providing higher brightness and deeper saturation. The present invention discloses a plurality of high brightness layouts for displays. These layouts, in turn, may be driven by various Gamut Mapping Algorithms (GMA) - either in the prior art or as disclosed in many application cited herein. Further, with the use of SubPixel Rendering (SPR) algorithms as disclosed in applications cited herein, such panels may maintain color accuracy while lowering cost and increasing contrast.

As disclosed on other application cited herein one one embodiment of a SPR algorithm treats the White subpixel as another color primary. Starting from color theory basics, this embodiment transforms the values of the input RGB using linear matrix multiplication. This results in a transform that maintains the hue and saturation of all colors.

The brightness increase from RGB to RGBW may be linear and a constant multiplier for all colors inside of the RGBW brightness/saturation gamut envelope. In the unlikely event a bright, saturated color in the image exceeds the RGBW brightness/saturation gamut envelope, one embodiment maps the color to the brightest color at that same hue and saturation that the display may render. This may be a reasonable trade-off, as the human vision system does not measure absolute brightness, only relative brightness. Further, very bright, highly saturated colors are an infrequent occurrence in natural images. Thus lowering the peak brightness of a highly saturated color slightly does not severely distort an image; while color saturation and hue are generally recognized and noticeable when they are distorted.

### High Brightness Layouts For Displays

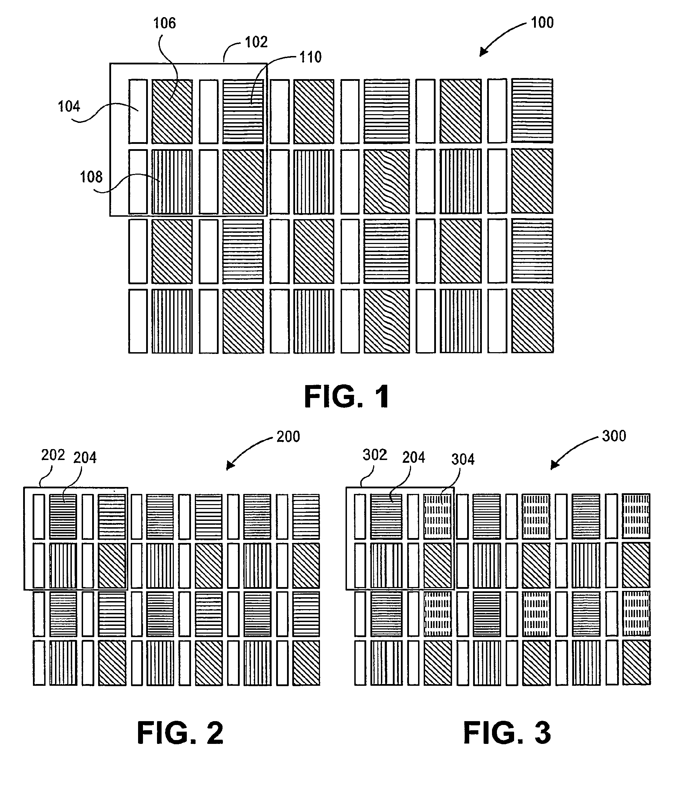

Having discussed some of the advantages and trade-offs of high brightness (e.g. RGBW) layouts, several comparative examples and embodiments of such layouts will now be disclosed. Figure 1 depicts one comparative layout 100. Layout 100 substantially comprises a plurality of repeating subpixel group 102 further comprising white (e.g. no color filter) 104, green 106, red 108 and blue 110 subpixels. As may be seen, the white subpixels are the majority number of all the subpixels and may optionally comprise a smaller dimension and/or area than the other colored subpixels. The value of placing the white on the majority, thinner, subpixels is that they provide high Modulation Transfer Function (MTF) depth. The same effect is given to the higher occurrence of green subpixels as compared to red and blue subpixels.

For subpixel rendering this display, the white subpixels may be mapped one to one with an incoming conventional data set (e.g. RGB or any other suitable data format). The colors may then be subpixel rendered, filtered to remove chromatic aliasing to maintain proper color, in the manners described in several applications cited herein. Also, the phase of the planes may be adjusted to be either coincident with the incoming data set or 180° out of phase with the white subpixel alignment as desired. The first may be suitable for text and other non bandlimited images, the second may be suitable for pictures or supersampling subpixel rendering of text, glyphs, etc. The color subpixel locations may also benefit from interpolation/subpixel rendering for proper digital image reconstruction of bandlimited images.

It should be noted that the backlight color temperature may be adjusted to have more magenta, red and blue, energy than that for the typical RGB LCD to give a balanced white. Alternatively, the green subpixels may be adjusted towards the upper green point on the CIE 1931 chart, decreasing its brightness but increasing its color saturation, to give better color gamut and proper white balance. Another alternative might be to combine the effects of the above two comparative examples. It should also be noted that this layout has an MTF Limit (MTFL) at the Nyquist limit of the white subpixels in all directions. MTFL may be thought of as the highest number of black & white lines that may be simultaneously rendered without chromatic aliasing.

For every subpixel layout shown in the present disclosure having a "white" subpixel, all of the "white" subpixels may be replaced with "yellow", or "subpixels grey" i.e. not colored but fully transmissive) Yellow, or grey do not have the same transmissivity as white does; however, yellow, or grey do present high transmissivity and would also provide a "high" brightness performance.

Two embodiments of high brightness layouts according to the present invention are shown in Figures 2 and 3. As with Figure 1, the white subpixels are the majority subpixels and may optionally be of decreased size or dimension. This gives high MTF Limit performance. The repeating pattern 202 in Figure 2 comprises red, green, and blue subpixels - as well as a cyan subpixel 204 (shown in finer horizontal hatching lines than the blue subpixels in these Figures). This may perhaps have more blue resolution than may be required, but the arrangement should be straight-forward to manufacture and subpixel render. For white color balance, the backlight may be more red energy, to counter the increased transmission of cyan, than the typical backlight for an RGB LCD display. Alternatively, the green and cyan may be darker, purer colors, towards the green peak of the CIE 1931 chart, resulting in a high color temperature display. This arrangement may allow for a bright, high MTF Limit, high SPR Moiré Limit, high color gamut display. Given that the white subpixel adds brightness to the system and that the use of the cyan color tends to give a wider color gamut, it may be advantageous to set the color points of the minority subpixels to be deeply saturated to result in a wide color gamut.

Figure 3 depicts an alternative for a five color system, RGMCW system, allowing even higher MTF Limit performance at the expense of deep blue performance. The repeating subpixel group 302 comprises red, green, cyan (204) and magenta (304) subpixels. In another embodiment, it may be possible to vertically displace the white majority subpixels from the minority subpixel grid 180° to expand the SPR Moiré Limit to a full circle. As these layouts have a square grid of white subpixels, the monochromatic MTF Limit displayed is a square MTF Limit boundary, matching that of the conventional RGB Stripe system.

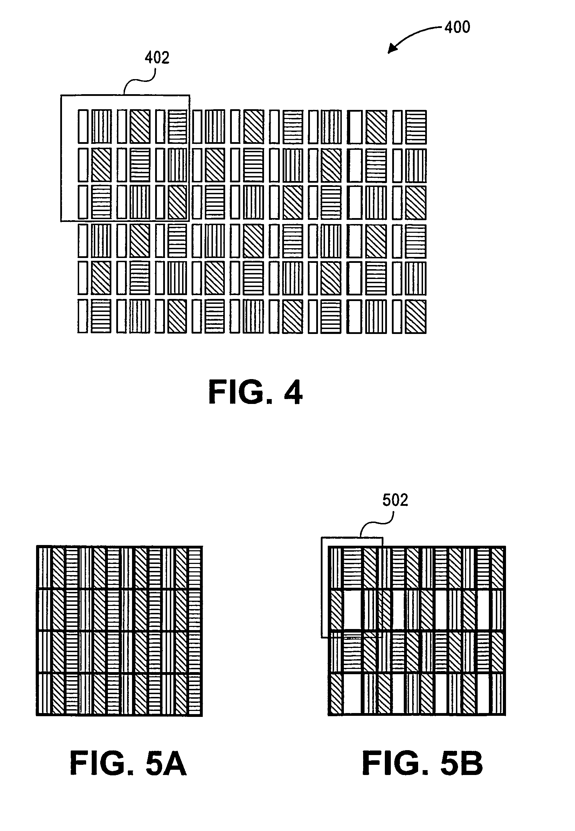

Figure 4 is yet a comparative example of a high brightness layout 400. Its repeating subpixel group is a 3 x 6 subpixel group 402 where the colored subpixels comprise red, green and blue subpixels in a mosaic pattern. Here the white subpixels are again the majority subpixels and are optionally more narrow that the other colored subpixels. The RGB colored subpixels are equal in number and size. This display may have the virtue of using a conventional backlight color and having pure white at maximum brightness when all of the subpixel values are full "on". This panel may also be immune to color shifts when mask shifts occur during manufacturing.

This panel tends to have high Luminance MTF Limit out into the corners as well as an extended Moiré Limit. However, it may have a highly asymmetrical chrominance MTF Limit, as with the classic Mosaic pattern. As one third of the panel area is high brightness white, the brightness is expected to be significantly higher than a traditional RGB panel using the same color filter points. This added brightness of the white may be used to trade-off some of the brightness gain for color gamut increase for a TV or HDTV product, by using higher saturation, but lower transmission color filters, as previously described.

As an alternative, the subpixel width ratio could be altered as desired for white/color brightness trade-off. For example, one could set the two sizes identically, giving a brighter white value, but lower saturated color brightness. This example has the added benefit of using the same size subpixels, with an aspect ratio of one-to-two (1:2) -- or, alternatively, one-to-three (1:3)being very easy to design and manufacture with present design rules. Yet another alternative might be to place the red, green and blue subpixels in vertical or horizontal stripes.

In the co-pending '094 application, the layout of Figure 5B has been proposed where the pixel size has an aspect ratio of 2:3 (width:height). This may result in increased pixel visibility when compared to RGB stripe at same resolution. Thus, Figure 5B shows a similar layout repeating group 502 with red, green, blue and white subpixels; but with a one-to-three (1:3) aspect ratio of conventional RGB stripe, shown for comparison in Figure 5A. One advantage is that the layout may utilize the existing RGB-stripe TFT array.

It should be noted that the pixel sizes are identical but the color order is changed. The repeat cycle is 2x3 pixels. The white pixels are shown in line within a row, but they can also be made to alternate for another comparative example. Resolution for this design should be 2x in horizontal axis compared to RGB stripe and 1x in vertical. Subpixel rendering can be adjusted to perform scaling in horizontal, or a video chip can be used to sample the data at 2x rate in horizontal axis. In either case, the performance of the LCD should be improved with less Moiré noise and higher MTF. Brightness gain for 25% color filter transmission should be ((5/6)*25+(1/6)*100)/25=37.5/25=1.5.

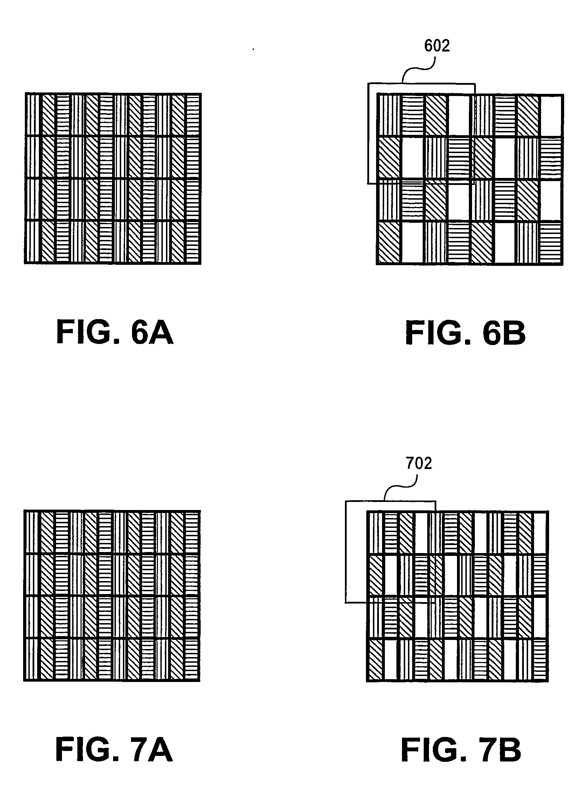

Figure 6B is yet another comparative example (shown next to RGB striped panel Figure 6A) that has a repeating group 602. In this comparative example the subpixels are of substantially equal size to maintain white balance. The repeat group 602 is 2x4 subpixels. It should be noted that the number of colors is the same within a repeat group (R,G,B,W). This should result in balanced white with existing backlights. In this case the horizontal and vertical resolution should be the same as RGB stripe, but the number of column drivers and TFTs is reduced by 1/3. Brightness gain depends on color filter transmission; assuming 25% transmission (typical) for colored filters and 100% for white, then transmission for white screen is (3/4)*25+(1/4)*100= 175/4 = 43.75% which is roughly a gain of 43.75/25 = 1.75.

Figure 7B (shown next to RGB stripe layout Figure 7A for comparison) is a variation of Figure 6B. In this case, the subpixel repeating group 702 is the same as group 602 but in the 1:3 aspect ratio. In this case, the resolution in the horizontal tends to be increased by 1.5x. This design uses existing TFT array and drive electronics with no cost savings, but resolution and brightness tends to be increased. Brightness gain is similar as noted above

Now, brightness with the novel high brightness layouts disclosed herein may have an impact in the portable (e.g. cell phone) application and the TV market as a consequence. As with typical RGB-stripe LCDs utilize, the transmissivity of the LCD is typically 5-10%, depending on color filter and polarizer transmission, as well as "aperture ratio" of TFT array. Thus to achieve 500 cd/m2 output, as much as 5000-10000 cd/m2 output from the backlight may be required. This can increase cost and increase heat of the TV system. In portable applications, it can reduce battery life.

With the high brightness layouts disclosed herein, the backlight brightness may be reduced by as much as one half as required by conventional RGB striped systems having substantially the same resolution. This decrease in backlight brightness is made possible by (a) increasing the aperture ratio by using these novel layouts, and (b) increasing transmission of the system by adding white subpixels. In the embodiments of the present invention, the brightness of the system may improve by up to 1.75x or, alternatively, the power can be reduced by more than 40%. In the case of LCD TV for home use, this can mean a reduction in the number of lamps from 16 to 10, for significant power, cost, and heat savings, while maintaining average brightness.

For all of these high brightness layouts, it is possible to discuss a "Figure of Merit" (FOM) to help compare the performance of these layouts. A simplified FOM might be the number of pixels expressed by the MTFL in each axis divided by the subpixels, expressed as a percentage.

For example, the conventional RGBW "Quad" pattern which has as a repeating group:
G B
R W
in a square pattern.

For large billboards, the Quad pattern is implemented by four incandescent lamps arranged in a square pattern repeat unit. The colored primaries are formed by pigment paints on the lamps. The brightness loss is significant, thus the unfiltered white lamp provides much needed brightness. The Quad pattern is typically treated as a square pixel. Although subpixel rendering may be applied (and thus improve), the Quad pattern is not as optimal as the novel layouts disclosed herein - as the Quad requires two lines of subpixels in any axis to draw a single white line. Since it takes four subpixels to equal one 'pixel', the FOM value is 25%.

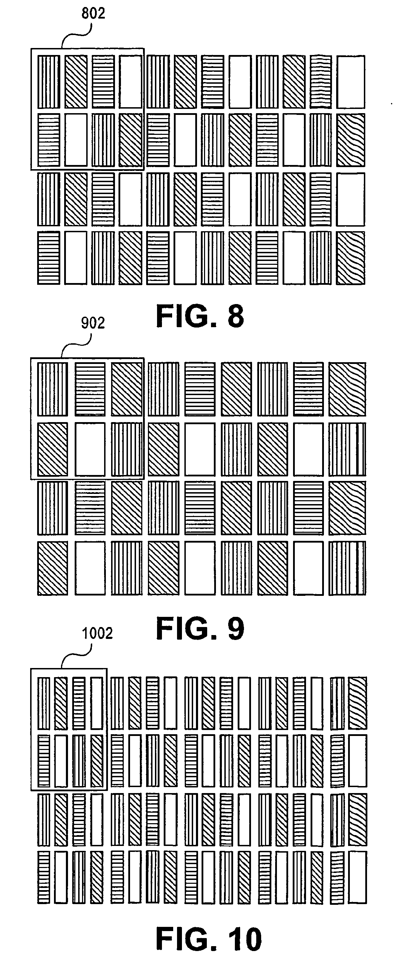

Figure 8 is yet another comparative example substantially comprising repeating group 802 with its subpixels in a 1:2 aspect ratio. This layout may have less edge boundaries that give rise to liquid crystal disinclinations, and thus has higher contrast than an LCD based on the RGBW Quad and even the RGB Stripe. This layout, like the Quad above, has 25% white area, thus it can have approximately 75% to 100% higher brightness than an RGB Stripe panel with the same resolution. It should be noted that each color is on a square grid at 45°. This layout requires only one row of subpixels to draw a single white line, while it still requires two subpixel columns. Thus, the Figure of Merit value is thus 50%.

Figure 9 is yet another comparative example substantially comprising repeating group 902. It may be advantageous for very high resolution (300+ dpi) mobile phones. As blue resolution is reduced in this layout, it may be desirable to use a high color temperature backlight to ensure that enough blue light is available to keep the panel at a desired white color when all of the subpixels are turned on to full value. As the white area is only 17%, the brightness increase is approximately 50%. The aspect ratio of the subpixels may be two-to-three (2:3) (or alternatively 1:3). For the layout of Figure 9, it may be seen that the FOM for this layout is 66%.

Figure 10 is yet another comparative example having subpixel repeating group 1002. As the subpixels remain at one-to-three (1:3) aspect ratio, it may be easy to utilize existing backplanes for this layout. This layout would then have a higher MTFL in the horizontal axis than the conventional RGB it replaces. It would also be approximately 75% brighter. The additional horizontal resolution may further reduce moiré distortion. If the input signal has higher resolution, such as scaling down a 1080i signal to a 720p HDTV LCD, or 720p on a 480i TV, this panel may show up to 50% higher horizontal resolution than the RGB Stripe panel, thus showing the full horizontal resolution of the higher resolution format.

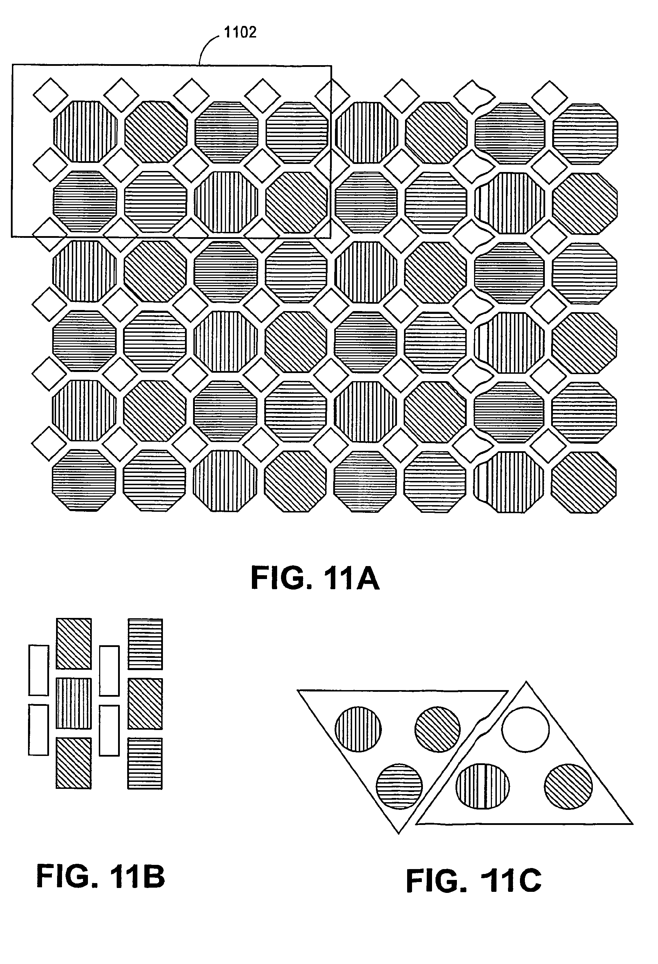

Figure 11A is yet another comparative example of a high brightness layout having a 4 x 8 subpixel repeating group 1102. As may be seen, the subpixels are of a different shape than the traditional rectangular. The white subpixels (shown without hatching) are the majority subpixels and are optionally of a smaller size or dimension as the colored subpixels which comprise red, green, blue and cyan in this comparative example. As may be seen, the white subpixels could be interstitial (e.g. displaced 180 degrees) to the colored subpixels. As may also be seen, the subpixel repeating group 1102 is larger than the other ones shown in the other figures because the color subpixels are placed on a hex grid. One possible advantage of a hex grid is that it tends to scatter the Fourier energies in more directions and points. This may be especially useful for the dark luminance wells caused by the blue subpixels. Another possible advantage is that each row contains all four colors as well as the white subpixels, allowing for horizontal lines to be black and white, fully sharpened, without chromatic aliasing. It will be appreciated that all of the subpixel repeating groups in all of the Figures shown herein may also be placed on a hex grid in a similar fashion and is contemplated within the scope of the present invention.

Figure 11B is yet another comparative example of a high brightness layout where the white majority subpixels are vertically displaced from the minority subpixels. This tends to expand the SPR Moire Limit to a full circle. If the layouts have a square grid of white subpixels, the monochromatic MTF Limit displayed is a square MTF Limit boundary, matching that of the conventional RGB stripe system. It will be appreciated that all of the layouts disclosed herein may be made to have the white subpixels so vertically displaced and the scope of the present invention encompasses these alternatives. Figure 11C is yet another comparative example of a high brightness layout in which a white subpixel replaces a blue subpixel in a delta triad pattern. Although the subpixels are shown as dots in Figure 11C, they may, of course, be implemented as rectangular subpixels - or in many other shapes - as desired.

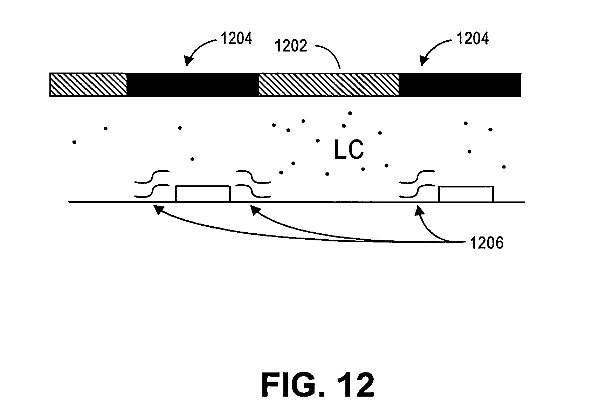

As was mentioned above, LCD contrast is set by many parameters, including light leakage from disclinations or other LC distortions around the edges of subpixels. To cancel the light coming from these regions, the black matrix may be enlarged to cover this region. This may reduce light transmission, but also may improves contrast. Figure 12 shows one possible embodiment. Black matrix is enlarged, adjacent to colored filter 1202, and tends to hide the disinclination regions 1206 below.

In many of the embodiments disclosed herein, the layout uses subpixels that are wider than normal RGB stripe, which tends to result in 10-100% increase in aperture ratio, depending on pixel density. The black matrix may be held constant and the light transmission increases. However, it may also be desirable to "give up" some of the light transmission gain and increase the black matrix width to cover more of the disclination region at the edge of the pixel. This may improve the overall contrast by reducing the dark state brightness of the LCD. The bright state brightness may be higher owing to the increased transmission; thus the contrast ratio will be improved. Further, the black matrix may be differentially adjusted for different colored regions, subpixels, such that the brighter subpixels, such as white, green, or even cyan, have more area at the periphery covered by the black matrix to reduce leakage from the disinclinadons, thus increasing the contrast while maintaining to some degree, the saturated brightness of the darker colors such as red and blue. Each of the colored subpixels may be thus adjusted independently, as desired. For example, the white may have the most area covered by the black matrix to have the greatest impact on the contrast of images.

While disclinations have been described as the source of light leakage around the edges of pixels, the present invention is not restricted to this phenomenon alone. In other designs, light leakage may be caused by field effects caused by the edge of electrodes, such as chevron patterns in MVA or IPS designs. The enlarged black matrix will help hide these sources of light leakage as well. It should be appreciated that this concept applies equally well to layout that are 3-color (i.e. using only red, green and blue as subpixels) or other multiprimary layout (i.e. not using white as a subpixel) - as well as any RGBW design.

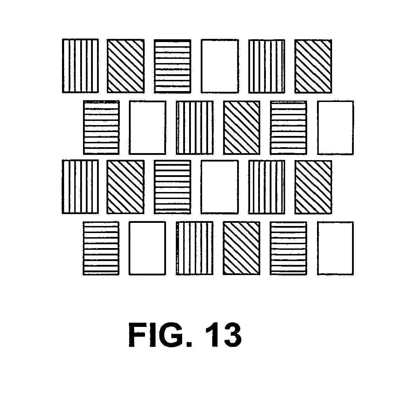

Figure 13 is one comparative example of a delta triad subpixel layout substantially corresponding to the color assignments in Figure 11C.

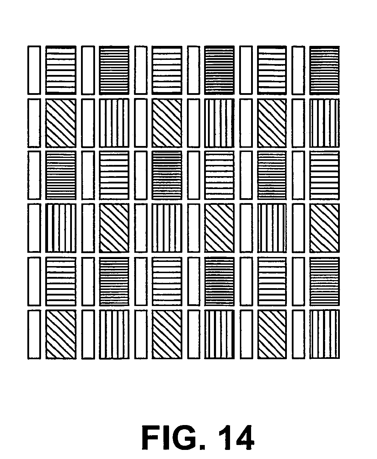

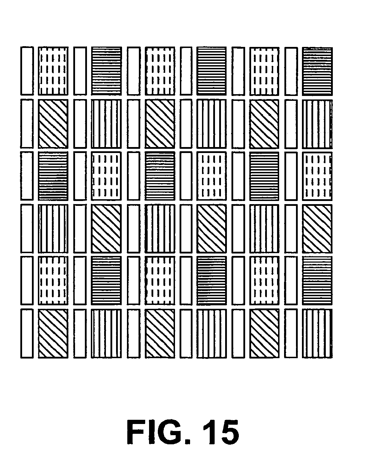

Figures 14 and 15 are additional comparative examples that are similar to Figures 2 and 3 wherein further the individual colored subpixels are placed on hex grid, as opposed to a square grid.

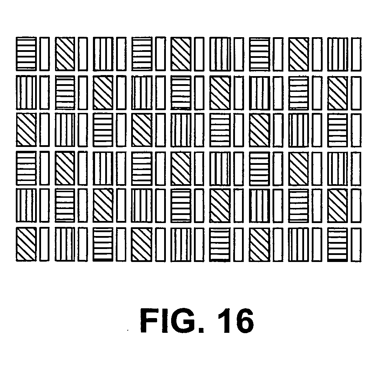

Figure 16 is an additional comparative example that is similar to Figure 4 but further wherein the colored subpixels form a different diagonal striping pattern as seen in Figure 4.

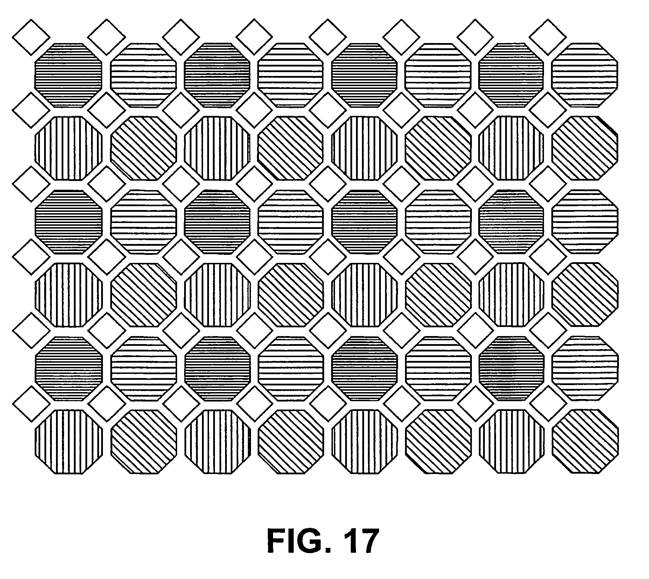

Figure 17 is another comparative example that is similar to Figure 11A but wherein the single color planes are placed on a square grid as opposed to a hex grid.

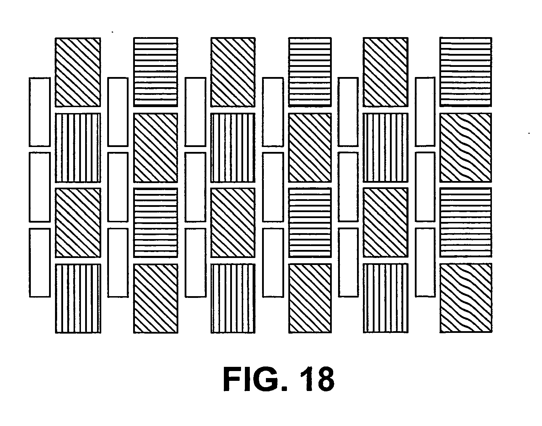

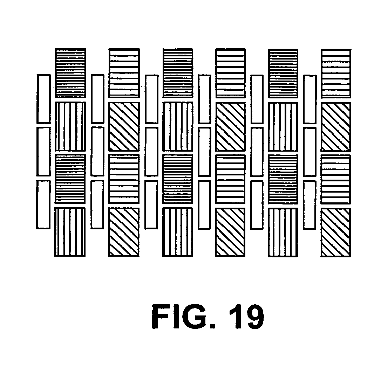

Figures 19 20 are embodiments of Figures 2 and 3 previously shown herein - but with the white subpixels displaced as shown. Figures 18 and 21 through 24 show further comparative examples.

Figures 25, 26, 27 and 28 are comparative examples of several of Figures previously shown herein - but depicted in mirror image.

While the invention has been described with reference to an exemplary embodiment, it will be understood by those skilled in the art that various changes may be made claims without departing from the scope of the claims. In addition, many modifications may be made to adapt a particular situation or material to the teachings without departing from the scope the claims Therefore, it is intended that the invention not be limited to the particular embodiment disclosed as the best mode contemplated for carrying out this invention, but that the invention will include all embodiments falling within the scope of the appended claims.

## Claims

1. A liquid crystal display comprising an two-dimensional arrangement of subpixels, the arrangement of subpixels consisting of a plurality of a single two-dimensional 2x4 subpixel repeating group (102), including 2 rows and 4 columns of subpixels, **characterised in that** said single subpixel repeating group (102) is one of
W C W B W C W M
W R W G, and W R W G,
wherein G, R, B, C and M represent a green (106), a red (108), a blue (110), a cyan (204) and a magenta (304) color subpixel, respectively, and wherein W represents
a white subpixel or
a yellow subpixel or

2. The liquid crystal display of Claim 1 wherein the W subpixels (104) are of smaller size than the G, R, B, C or G,R,C M subpixels.

3. The liquid crystal display of Claim 1 where in the subpixels are rectangular and wherein said G, R, B, C or G, R, C, M subpixels each have a first aspect ratio and said W subpixels (104) each have a second aspect ratio different from said first aspect ratio different from said first aspect ratio.

4. The liquid crystal display of Claim 1 where in the subpixels are rectangular and) wherein said G, R, B, C or G, R, C, M subpixels and said W subpixels (104) have the same aspect ratio.

5. The liquid crystal display of Claim 3 wherein said first aspect ratio is 1:2 and said second aspect ratio is 1:3.

6. The liquid crystal display of Claim 1 wherein said subpixels are of rectangular shape.

7. The liquid crystal display of Claim 1 wherein arranged to cover a black matrix (1204) is arranged to cover disinclination regions (1206) around the edges of the subpixels.

8. The liquid crystal display of Claim 7 wherein the black matrix (1204) covers a larger area of disinclination regions (1206) in the W subpixels than in the G,R,B,C or G,R,C,M subpixels.

9. The liquid crystal display of Claim 1 wherein said display further comprises a backlight and the colour temperature of said backlight is adjusted such that a balanced white colour is displayed when all subpixels are switched fully on.

10. The liquid crystal display of Claim 1 wherein the W subpixels (104) are vertically displaced with respect to the G, R, B, C or the G, R, C, M subpixels.

11. The liquid crystal display of claim 1 further comprising a backlight wherein the display has a balanced white point when all subpixels are switched fully on; and wherein at least one of the G, R, B, C or G, R, C, M subpixels has a greater pixel area than said W subpixels.

12. The liquid crystal display of Claim 11 wherein said display further comprises a black matrix (1204), said black matrix (1204) being formed in an area covering regions of disinclinations around the edges of the subpixels.

13. The liquid crystal display of Claim 12 wherein said black matrix covers a larger area over W subpixels (104) than over the G, R, B, C or G, R, C, M subpixels.

14. The liquid crystal display of Claim 11 wherein said W subpixels (104) are vertically displaced from said G, R, B, C or G, R, C, M subpixels.

## Patentansprüche

1. Flüssigkristallanzeige mit einer zwei-dimensionalen Anordnung von Subpixeln, wobei die Anordnung von Subpixeln aus einer Vielzahl von einzelnen zwei-dimensionalen 2 x 4 Subpixel-Wiederholgruppen (102) besteht und 2 Reihen und 4 Spalten von Subpixeln umfasst, **dadurch gekennzeichnet, dass** besagte einzelne Subpixel-Wiederholgruppe (102) eines der folgenden
WCWB WCWM
WRWG und W R W G ist,
wobei G, R, B, C und M jeweils ein grünes (106), ein rotes (108), ein blaues (110), ein türkisfarbenes (204) und ein magentafarbenes (304) Farb-Subpixel darstellt, und wobei W
ein weißes Subpixel oder
ein gelbes Subpixel darstellt.

2. Flüssigkristallanzeige nach Anspruch 1, wobei die W-Subpixel (104) eine kleinere Größe aufweisen als die G-, R-, B-, C- oder G-, R-, C-, M-Subpixel.

3. Flüssigkristallanzeige nach Anspruch 1, wobei die Subpixel rechteckig sind und besagte G-, R-, B-, C- oder G-, R-, C-, M-Subpixel jeweils ein erstes Bildseitenverhältnis und besagte W-Subpixel (104) jeweils ein zweites Bildseitenverhältnis, das sich von dem besagten ersten Bildseitenverhältnis unterscheidet, aufweisen.

4. Flüssigkristallanzeige nach Anspruch 1, wobei die Subpixel rechteckig sind und besagte G-, R-, B-, C- oder G-, R-, C-, M-Subpixel und besagte W-Subpixel (104) dasselbe Bildseitenverhältnis aufweisen.

5. Flüssigkristallanzeige nach Anspruch 3, wobei besagtes erstes Bildseitenverhältnis 1:2 ist und besagtes zweites Bildseitenverhältnis 1:3 ist.

6. Flüssigkristallanzeige nach Anspruch 1, wobei besagte Subpixel rechteckig sind.

7. Flüssigkristallanzeige nach Anspruch 1, wobei eine schwarze Matrix (1204) so angeordnet ist, dass sie Abneigungsbereiche (1206) um die Ecken der Subpixel herum abdeckt.

8. Flüssigkristallanzeige nach Anspruch 7, wobei die schwarze Matrix (1204) eine größere Fläche der Abneigungsbereiche (1206) in den W-Subpixeln als in den G-, R-, B-, C- oder G-, R-, C-, M-Subpixeln abdeckt.

9. Flüssigkristallanzeige nach Anspruch 1, wobei besagte Anzeige des Weiteren eine Hintergrundbeleuchtung aufweist, und wobei die Farbtemperatur der besagten Hintergrundbeleuchtung so angepasst wird, dass eine ausgeglichene weiße Farbe angezeigt wird, wenn alle Subpixel voll eingeschaltet sind.

10. Flüssigkristallanzeige nach Anspruch 1, wobei die W-Subpixel (104) in Relation zu den G-, R-, B-, C- oder den G-, R-, C-, M-Subpixeln vertikal verschoben sind.

11. Flüssigkristallanzeige nach Anspruch 1, die des Weiteren eine Hintergrundbeleuchtung aufweist, wobei die Anzeige einen ausgeglichenen weißen Punkt aufweist, wenn alle Subpixel voll eingeschaltet sind; und
wobei mindestens eines der G-, R-, B-, C- oder der G-, R-, C-, M-Subpixel eine größere Pixelfläche aufweist als besagte W-Subpixel.

12. Flüssigkristallanzeige nach Anspruch 11, wobei besagte Anzeige des Weiteren eine schwarze Matrix (1204) aufweist, wobei besagte schwarze Matrix (1204) in einer Fläche ausgebildet ist, die die Abneigungsbereiche um die Ecken der Subpixel herum abdeckt.

13. Flüssigkristallanzeige nach Anspruch 12, wobei besagte schwarze Matrix eine größere Fläche über W-Subpixeln (104) als über den G-, R-, B-, C- oder G-, R-, C-, M-Subpixeln abdeckt.

14. Flüssigkristallanzeige nach Anspruch 11, wobei besagte W-Subpixel (104) vertikal zu den besagten G-, R-, B-, C- oder den G-, R-, C-, M-Subpixeln verschoben sind.

## Revendications

1. Afficheur à cristaux liquides comprenant un agencement bidimensionnel de sous-pixels, l'agencement de sous-pixels composé d'une pluralité d'un groupe (102) de répétition de sous-pixels bidimensionnel 2*4 unique comportant 2 lignes et 4 colonnes de sous-pixels, **caractérisé en ce que** ledit groupe (102) de répétition de sous-pixels unique est l'un de
W C W B W C W M
W R W G, et W R W G,
où G, R, B, C et M représentent un sous-pixel de couleur verte (106), rouge (108), bleue (110), cyan (204) et magenta (304), respectivement, et où W représente
un sous-pixel blanc ou
un sous-pixel jaune

2. Afficheur à cristaux liquides de la revendication 1 dans lequel les sous-pixels W (104) sont de taille plus petite que les sous-pixels G, R, B, C ou G, R, C, M.

3. Afficheur à cristaux liquides de la revendication 1 dans lequel les sous-pixels sont rectangulaires et où lesdits sous-pixels G, R, B, C ou G, R, C, M ont chacun un premier rapport largeur/hauteur et lesdits sous-pixels W (104) ont chacun un deuxième rapport largeur/hauteur différent dudit premier rapport largeur/hauteur.

4. Afficheur à cristaux liquides de la revendication 1 dans lequel les sous-pixels sont rectangulaires et où lesdits sous-pixels G, R, B, C ou G, R, C, M et lesdits sous-pixels W (104) ont le même rapport largeur/hauteur.

5. Afficheur à cristaux liquides de la revendication 3 dans lequel ledit premier rapport largeur/hauteur est de 1:2 et ledit deuxième rapport largeur/hauteur est de 1:3.

6. Afficheur à cristaux liquides de la revendication 1 dans lequel lesdits sous-pixels sont de forme rectangulaire.

7. Afficheur à cristaux liquides de la revendication 1 dans lequel une matrice noire (1204) est agencée pour couvrir des régions de disinclinaison (1206) autour des bords des sous-pixels.

8. Afficheur à cristaux liquides de la revendication 7 dans lequel la matrice noire (1204) couvre une surface plus grande de régions de disinclinaison (1206) dans les sous-pixels W que dans les sous-pixels G, R, B, C ou G, R, C, M.

9. Afficheur à cristaux liquides de la revendication 1 dans lequel ledit afficheur comprend en outre une unité de rétroéclairage et la température de couleur de ladite unité de rétroéclairage est ajustée de sorte qu'une couleur blanche équilibrée soit affichée lorsque tous les sous-pixels sont complètement allumés.

10. Afficheur à cristaux liquides de la revendication 1 dans lequel les sous-pixels W (104) sont déplacés verticalement par rapport aux sous-pixels G, R, B, C ou G, R, C, M.

11. Afficheur à cristaux liquides de la revendication 1 comprenant en outre une unité de rétroéclairage où l'afficheur a un point blanc équilibré lorsque tous les sous-pixels sont entièrement allumés; et
où au moins l'un des sous-pixels G, R, B, C ou G, R, C, M a une surface de pixel plus grande que lesdits sous-pixels W.

12. Afficheur à cristaux liquides de la revendication 11 dans lequel ledit afficheur comprend en outre une matrice noire (1204), ladite matrice noire (1204) étant formée dans une surface couvrant des régions de disinclinaisons autour des bords des sous-pixels.

13. Afficheur à cristaux liquides de la revendication 12 dans lequel ladite matrice noire couvre une surface plus grande sur les sous-pixels W (104) que sur les sous-pixels G, R, B, C ou G, R, C, M.

14. Afficheur à cristaux liquides de la revendication 11 dans lequel lesdits sous-pixels W (104) sont déplacés verticalement à partir desdits sous-pixels G, R, B, C ou G, R, C, M.
